# FASCICULE DE BREVET EUROPEEN

(11) **EP 1 672 691 B1**
(45) Date de publication et mention de la délivrance du brevet: **26.10.2011**
(21) Numéro de dépôt: 05292594.8
(22) Date de dépôt: 07.12.2005
(51) Int. Cl.: H01L 23/498, H05K 1/11

(54) **Dispositif de connexion électrique d'une puce de circuits intégrés sur une plaque principale**
Elektrisches Verbindungsstück für integrierten Schaltkreis auf einem Hauptträger
Electrical connector for integrated circuit on a mainboard

(30) Priorité: 17.12.2004 FR 0413482
(43) Date de publication de la demande: 21.06.2006
(73) Titulaire: STMICROELECTRONICS SA, 92120 Montrouge (FR)
(72) Inventeur: Bormann, Pierre, 38210 Tullins (FR); Morineau, Luc, 38920 Crolles (FR); Chavade, Jacques, 38430 Moirans (FR)
(74) Mandataire: Casalonga, Axel

(56) Documents cités:
- US-A- 5 847 936
- US-B1- 6 448 639
- "ENHANCED ACCESS CHIP FOOTPRINT" IBM TECHNICAL DISCLOSURE BULLETIN, IBM CORP. NEW YORK, US, vol. 38, no. 2, 1 février 1995 (1995-02-01), pages 203-204, XP000502444 ISSN: 0018-8689

## Description

La présente invention concerne le domaine des dispositifs de connexion électrique d'une puce de circuits intégrés.

Pour installer et connecter une puce de circuits intégrés sur une plaque principale qui présente sur une première face des plots de connexion électrique et qui présente des pistes de connexion électrique reliées d'une part à ces plots et d'autre part à des composants électroniques montés sur cette plaque principale, il est connu de prévoir une plaque intermédiaire de connexion électrique parallèle à ladite plaque principale.

Cette plaque intermédiaire présente des premiers plots de connexion électrique ménagés sur une première face en vue de la connexion de ladite puce, des seconds plots de connexion électrique ménagés sur une seconde face et des moyens de liaison électrique entre lesdits premiers et seconds plots.

Des billes de connexion électrique sont placées dans un espace séparant la première plaqué et la seconde plaque et sont interposées entre lés seconds plots de ladite première plaque et les plots de ladite seconde plaque.

Selon une réalisation courante, il est prévu, dans ledit espace, une zone périphérique qui comporte une matrice périphérique de cinq rangées de billes, une zone centrale qui comporte une matrice centrale de billes et une zone médiane exempte de billes qui sépare la zone périphérique et la zone centrale.

La plaque principale comporte des pistes rayonnant vers l'extérieur qui sont reliées aux billes de la rangée extérieure de la matrice périphérique et des pistes rayonnantes qui passent entre les billes de la rangée extérieure et sont reliées aux billes de la seconde rangée extérieure adjacente à cette rangée extérieure.

La plaque principale comporte, dans la zone médiane, une matrice de deux rangées extérieures de vias de connexion électrique adjacentes à la matrice périphérique et comporte, sur sa première face précitée, des courtes pistes rayonnant vers l'intérieur qui relient les billes des deux rangées intérieures de la matrice périphérique et lesdits vias en passant alternativement entre les billes de la rangée intérieure de billes et de la rangée extérieure de vias.

La plaque principale comporte, dans la zone médiane, une matrice de deux rangées intérieures de vias de connexion électrique adjacentes à la matrice périphérique et comporte, sur sa première face précitée, des courtes pistes rayonnant vers l'extérieur qui relient les billes des deux rangées extérieures de la matrice centrale et lesdits vias en passant alternativement entre les billes de la rangée extérieure de billes de cette matrice et de la rangée intérieure de vias.

La plaque principale comporte en outre, dans la zone périphérique, des vias de connexion électrique et des courtes pistes de connexion électrique qui relient ces vias aux billes de la rangée médiane de la matrice périphérique.

Cette implantation de vias dans la zone périphérique dans laquelle sont prévus les plots de connexion de la matrice périphérique pose des difficultés lorsque l'on cherche à réduire le pas les séparant.

Le document US-B1-6 448 639 décrit une plaque portant d'un côté une puce de circuits intégrés et de l'autre côté une disposition de billes de connexion électrique comprenant une matrice centrale, une matrice périphérique et une matrice intermédiaire.

Le document «ENHANCED ACCESS CHIP IBM TECHNICAL DISCLOSURE BULLETIN, IBM CORP. NEW YORK. US vol. 38, n°2, 1er février 1995, pages 203-204 » décrit une disposition alternées de rangées longitudinales de billes reliées entres elles et de rangées de billes indépendantes reliées à très faibles distances à des vias

La présente invention a pour but de remédier aux difficultés d'implantation de connexion électrique, tout en ne réduisant pas le nombre de connexions possibles entre une plaque principale et une plaque intermédiaire et éventuellement en augmentant ce nombre.

Le dispositif de connexion électrique selon l'invention, pour relier une puce de circuits intégrés à d'autres composants, comprend de préférence une plaque principale présentant sur une première face des plots de connexion électrique et des pistes de connexion électrique et dans laquelle sont ménagés des vias de connexion électrique, une plaque intermédiaire présentant des premiers plots de connexion électrique ménagés sur une première face en vue de la connexion de ladite puce, des seconds plots de connexion électrique ménagés sur une seconde face et des moyens de liaison électrique entre lesdits premiers et seconds plots, et des billes de connexion électrique placées dans un espace séparant la plaque principale et la plaque intermédiaire et interposées entre les plots de ladite plaque principale et les seconds plots de la plaque intermédiaire.

Selon l'invention, dans ledit espace, une zone périphérique comporte une matrice périphérique de quatre rangées de billes; une zone centrale comporte une matrice centrale de billes ; une première zone secondaire, adjacente et à l'intérieur de la zone périphérique, comporte une matrice de deux rangées de vias de connexion électrique ménagés dans la plaque principale et reliés par des pistes aux billes des deux rangées de billes adjacentes de la matrice périphérique ; et une seconde zone secondaire, adjacente et à l'estérieur de la zone centrale, comporte une matrice de vias de connexion électrique ménagés dans la plaque principale et reliés par des pistes à des billes de la matrice centrale.

Selon l'invention, la première zone secondaire et la seconde zone secondaire sont séparées par une zone intermédiaire.

Selon l'invention, ladite zone intermédiaire est divisée en au moins deux parties dont une comporte au moins une rangée complémentaire de billes de connexion électrique et une autre comporte des vias complémentaires de connexion électrique ménagés dans la plaque principale et reliés par des pistes aux billes de cette rangée complémentaire.

Selon l'invention, des pistes rayonnantes vers l'extérieur sont reliées aux billes des deux rangées de billes extérieures de la matrice périphérique.

Selon l'invention, lesdites billes ou plots et lesdits vias sont, respectivement les uns par rapport aux autres, disposés selon un pas constant.

Selon l'invention, ladite zone intermédiaire peut avantageusement comporter au moins deux rangées complémentaires de billes de connexion électrique et au moins deux rangées complémentaires de vias complémentaires de connexion électrique ménagés dans la seconde plaque, reliés par des courtes pistes.

La présente invention sera mieux comprise à l'étude d'un dispositif de connexion électrique d'une puce de circuits intégrés décrit à titre d'exemple non limitatif et représenté sur la dessin dans lequel :
- la figure 1 représente une coupe transversale d'un dispositif de connexion électrique selon l'invention, comprenant une plaque principale et une plaque intermédiaire,
- et la figure 2 représente une vue de dessus partielle de ladite plaque principale.

Le dispositif de connexion électrique 1 représenté sur le dessin comprend une plaque principale 2 de circuit imprimé, à une ou plusieurs couches, et une plaque intermédiaire 3 parallèle à la plaque principale 2 et séparée de cette dernière par un espace 4, cette plaque intermédiaire 3 présentant par exemple un pourtour carré.

Cet espace 4 présente une zone périphérique 5 dans laquelle est formée une matrice périphérique 6 de quatre rangées de billes de connexion électrique, repérées de l'extérieur vers l'intérieur par les références 7, 8, 9 et 10, et une zone centrale 11 dans laquelle est formée une matrice centrale carrée 12 de billes de connexion électrique 13.

L'espace 4 présente une première zone secondaire 14 adjacente à la zone périphérique 5 et à l'intérieur de cette dernière, dans laquelle est formée une matrice 15 de deux rangées de vias de connexion électrique ménagés dans la plaque principale 2, repérées de l'extérieur vers l'intérieur par les références 16 et 17.

L'espace 4 présente une seconde zone secondaire 18 adjacente à la zone centrale 11 et à l'extérieur de cette dernière, dans laquelle est formée une matrice 19 de deux rangées de vias de connexion électrique ménagés dans la plaque principale 2, repérées de l'extérieur vers l'intérieur par les références 20 et 21.

Entre la première zone secondaire 14 et la seconde zone secondaire 18 est prévue une zone intermédiaire 22 qui les sépare.

Dans l'exemple, cette zone intermédiaire 22 présente une partie 23 adjacente à la première zone secondaire 14 et à l'intérieur de cette dernière, dans laquelle est formée une matrice intermédiaire 24 de deux rangées de billes de connexion électrique, repérées de l'extérieur vers l'intérieur par les références 25 et 26.

La zone intermédiaire 22 présente une partie 27 adjacente d'une part à la seconde zone secondaire 18 et d'autre part à sa partie 22, dans laquelle est formée une matrice intermédiaire 28 de deux rangées de vias de connexion électrique ménagés dans la plaque principale 2, repérées de l'extérieur vers l'intérieur par les références 29 et 30.

La face frontale 31 de la plaque intermédiaire 3 porte en son milieu et à distance une puce 32 de circuits intégrés, par l'intermédiaire de billes de connexion électrique 33, et sa face arrière 34 présente des plots 35 disposés conformément aux billes de connexion électrique des matrices 6, 11 et 24 et sur lesquels ces billes sont respectivement soudées.

La plaque intermédiaire 3 porte un réseau 36 de pistes de connexion électrique, de surface et/ou intégrées, qui relient respectivement les billes de connexion électrique 33 et les plots 35.

La face frontale 36 de la plaque principale 2 présente des plots 37 disposés conformément aux billes de connexion électrique des matrices 6, 11 et 24 et sur lesquels ces billes sont respectivement soudées.

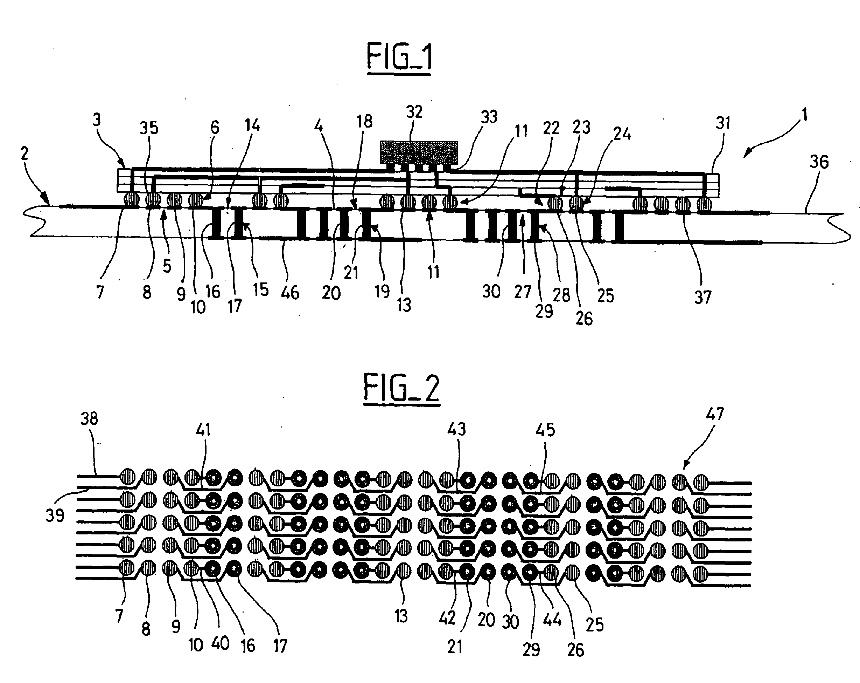

Comme le montre plus clairement la figure 2, la face frontale 36 de la plaque principale 2 porte des pistes rayonnantes 38 de connexion électrique qui sont reliées aux billes de connexion électrique 7 par l'intermédiaire des plots 37 correspondants et des pistes rayonnantes 39 qui passent entre ces billes 7 et sont reliées aux billes de connexion électrique 8 par l'intermédiaire des plots 37 correspondants.

Dans l'espace 4, la face frontale 36 de la plaque principale 2 porte des courtes pistes de connexion électrique 40 qui relient les billes de connexion électrique 10 et les vias 16 et des courtes pistes de connexion électrique 41 qui passent entre ces billes et ces vias et qui relient les billes de connexion électrique 9 et les vias 17.

De même, la face frontale 36 de la plaque principale 2 porte des courtes pistes de connexion électrique 42 et 43 qui relient les vias 20 et 21 aux billes centrales 13.

Dans l'espace 4, la face frontale 36 de la plaque principale 2 porte en outre des courtes pistes de connexion électrique 44 qui relient les billes de connexion électrique 26 et les vias 29 et des courtes pistes de connexion électrique 45 qui passent entre ces billes et ces vias et qui relient les billes de connexion électrique 25 et les vias 30.

La plaque principale 2 porte en outre un réseau de pistes de connexion électrique 46, sur sa face arrière et/ou intégrées, qui sont reliées aux vias précités.

Le réseau constitué par les pistes 38, le réseau constitué par les pistes 39 et le réseau de pistes de connexion électrique 46 sont reliés à des composants électriques ou électroniques, non représentés, portés par la plaque principale et situés à l'extérieur de la surface couverte par la plaque intermédiaire 3, ces composants étant ainsi reliés à la puce 32 par l'intermédiaire de la plaque intermédiaire 3.

Les billes des matrices 5, 11 et 24 et les vias des matrices 14, 18 et 28 sont avantageusement disposés selon un grande matrice 47 à pas constant.

La présente invention ne se limite pas à l'exemple ci-dessus décrit.

En particulier, les rangées intermédiaires de billes 25 et 26 et les rangées intermédiaires de vias 29 et 30 pourraient être disposées les unes par rapport aux autres de manière différente, par exemple en les alternant ou en plaçant les deux rangées de billes l'une à côté de l'autre et les rangées de vias de part et d'autre de ces rangées de billes et réciproquement.

Les nombres de rangées de billes et/ou de vias pourraient aussi être différents.

Bien d'autres variantes sont possibles sans sortir du cadre des revendications annexées.

## Revendications

1. Dispositif de connexion électrique d'une puce de circuits intégrés comprenant une plaque principale (2) présentant sur une première face des plots de connexion électrique et des pistes de connexion électrique et dans laquelle sont ménagés des vias de connexion électrique, une plaque intermédiaire (3) présentant des premiers plots de connexion électrique ménagés sur une première face en vue de la connexion de ladite puce, des seconds plots de connexion électrique ménagés sur une seconde face et des moyens' de liaison électrique entre lesdits premiers et seconds plots, et des billes de connexion électrique placées dans un espace séparant la plaque principale et la plaque intermédiaire et interposées entre les plots de ladite plaque principale et les seconds plots de la plaque intermédiaire,
**caractérisé par le fait que**, dans ledit espace (4), une zone périphérique (5) comporte une matrice périphérique (6) de quatre rangées de billes, une zone centrale (11) comporte une matrice centrale (12) de billes, une première zone secondaire (14), adjacente et à l'intérieur de la zone périphérique (5), comporte une matrice (15) de deux rangées de vias de connexion électrique ménagés dans la plaque principale et reliés par des pistes aux billes des deux rangées de billes adjacentes de la matrice périphérique (6) et une seconde zone secondaire (18), adjacente et à l'extérieur de la zone centrale, comporte une matrice (19) de vias de connexion électrique ménagés dans la plaque principale et reliés par des pistes à des billes de la matrice centrale ; que la première zone secondaire (14) et la seconde zone secondaire (18) sont séparées par une zone intermédiaire (22) ; que ladite zone intermédiaire (22) est divisée en au moins deux parties dont une (23) comporte au moins une rangée complémentaire de billes de connexion électrique et une autre (27) comporte des vias complémentaires de connexion électrique ménagés dans la plaque principale et reliés par des pistes aux billes de cette rangée complémentaire; que des pistes rayonnantes (38, 39) vers l'extérieur sont reliées aux billes des deux rangées de billes extérieures de la matrice périphérique, et que lesdites billes ou plots et lesdits vias sont, respectivement les uns par rapport aux autres, disposés selon un pas constant.

2. Dispositif selon la revendication 1, **caractérisé par le fait que** ladite zone intermédiaire (22) comporte au moins deux rangées complémentaires (23, 24) de billes de connexion électrique et au moins deux rangées complémentaires (29, 30) de vias complémentaires de connexion électrique ménagés dans la seconde plaque, reliés par des courtes pistes (42, 43).

## Claims

1. Device for the electrical connection of an integrated circuit chip comprising a main board (2) exhibiting on a first face electrical connection pads and electrical connection tracks and in which are made electrical connection vias, an intermediate board (3) exhibiting first electrical connection pads made on a first face with a view to the connection of the said chip, second electrical connection pads made on a second face and means of electrical linking between the said first and second pads, and electrical connection balls placed in a space separating the main board and the intermediate board and interposed between the pads of the said main board and the second pads of the intermediate board,
**characterized in that**, in the said space (4), a peripheral zone (5) comprises a peripheral matrix (6) of four rows of balls, a central zone (11) comprises a central matrix (12) of balls, a first secondary zone (14), that is adjacent and inside the peripheral zone (5), comprises a matrix (15) of two rows of electrical connection vias made in the main board and linked by tracks to the balls of the two adjacent rows of balls of the peripheral matrix (6) and a second secondary zone (18), that is adjacent and outside the central zone, comprises a matrix (19) of electrical connection vias made in the main board and linked by tracks to balls of the central matrix; that the first secondary zone (14) and the second secondary zone (18) are separated by an intermediate zone (22); and that the said intermediate zone (22) is divided into at least two parts one of which (23) comprises at least one complementary row of electrical connection balls and another of which (27) comprises complementary electrical connection vias made in the main board and linked by tracks to the balls of this complementary row; **in that** outwardly radiating tracks (38, 39) are linked to the balls of the two outside rows of balls of the peripheral matrix, and **in that** the said balls or pads and the said vias are, respectively relative to one another, disposed according to a constant pitch.

2. Device according to Claim 1, **characterized in that** the said intermediate zone (22) comprises at least two complementary rows (23, 24) of electrical connection balls and at least two complementary rows (29, 30) of complementary electrical connection vias made in the main board and linked by short tracks (42, 43).

## Patentansprüche

1. Elektrische Anschlussvorrichtung eines Chips von integrierten Schaltungen, mit einer Hauptplatte (2), die auf einer ersten Seite elektrische Anschlussplättchen und elektrische Anschlussleiterbahnen aufweist und in der elektrische Anschlusslücken eingerichtet sind, mit einer Zwischenplatte (3), die erste elektrische Anschlussplättchen, die auf einer ersten Seite gegenüber dem Anschluss des Chips angeordnet sind, zweite elektrische Anschlussplättchen, die auf einer zweiten Seite angeordnet sind, und elektrische Verbindungseinrichtungen zwischen dem ersten und dem zweiten Plättchen aufweist, und mit elektrischen Anschlusskugeln, die in einem Raum angeordnet sind, der die Hauptplatte und die Zwischenplatte trennt, und die zwischen die Plättchen der Hauptplatte und die zweiten Plättchen der Zwischenplatte eingefügt sind, **dadurch gekennzeichnet, dass** in dem Raum (4) eine Umfangszone (5) eine Umfangsmatrix (6) von vier Reihen von Kugeln aufweist, eine zentrale Zone (11) eine zentrale Matrix (12) von Kugeln aufweist, eine erste Sekundärzone (14), die der Umfangszone (5) benachbart und innerhalb dieser liegt, eine Matrix (15) von zwei Reihen von elektrischen Anschlusslücken aufweist, die in der Hauptplatte eingerichtet und durch Leiterbahnen mit den Kugeln der zwei benachbarten Reihen von Kugeln der Umfangsmatrix (6) verbunden sind, und eine zweite Sekundärzone (18), die der zentralen Zone benachbart und außerhalb dieser liegt, eine Matrix (19) von elektrischen Anschlusslücken aufweist, die in der Hauptplatte eingerichtet und über Leiterbahnen mit Kugeln der zentralen Matrix verbunden sind; dass die erste Sekundärzone (14) und die zweite Sekundärzone (18) durch eine Zwischenzone (22) getrennt sind; dass die Zwischenzone (22) in mindestens zwei Bereiche geteilt ist, von denen einer (23) mindestens eine komplementäre Reihe von elektrischen Anschlusskugeln und ein anderer (27) komplementäre elektrische Anschlusslücken aufweist, die in der Hauptplatte eingerichtet und über Leiterbahnen mit den Kugeln dieser komplementären Reihe verbunden sind; dass nach außen strahlende Leiterbahnen (38, 39) mit den Kugeln der zwei Reihen von äußeren Kugeln der Umfangsmatrix verbunden sind, und dass die Kugeln oder Plättchen und die Lücken jeweils zueinander in konstantem Abstand angeordnet sind.

2. Vorrichtung nach Anspruch 1, **dadurch gekennzeichnet, dass** die Zwischenzone (22) mindestens zwei komplementäre Reihen (23, 24) von elektrischen Anschlusskugeln und mindestens zwei komplementäre Reihen (29, 30) von in der Hauptplatte eingerichteten komplementären elektrischen Anschlusslücken aufweist, die durch kurze Leiterbahnen (42, 43) verbunden sind.
